# DEMANDE DE BREVET EUROPEEN

(11) **EP 0 886 311 A1**
(43) Date de publication de la demande: **23.12.1998**
(21) Numéro de dépôt: 98401494.4
(22) Date de dépôt: 18.06.1998
(51) Int. Cl.: H01L 21/66, H01L 21/306, G01B 11/06

(54) **Procédé de fabrication de composants semiconducteurs**

(30) Priorité: 19.06.1997 FR 9707635
(71) Demandeur: ALCATEL ALSTHOM COMPAGNIE GENERALE D'ELECTRICITE, 75008 Paris (FR)
(72) Inventeur: Starck, Christophe, 91700 Sainte Genevieve des Bois (FR); Le Gouezigou, Lionel, 91530 Le Val Saint Germain (FR)
(74) Mandataire: Fournier, Michel Robert Marie

(57) **Abrégé**

L'invention concerne un procédé de fabrication d'un composant semi-conducteur, comportant au moins une étape de gravure d'une couche supérieure formée sur un substrat.

Selon le procédé, on fait croître, avant la formation de la couche supérieure (2,3), au moins un ensemble (50) formé par des couches de marquage (10, 12, 20) séparées par des couches intermédiaires (11, 13, 19) d'épaisseurs prédéterminées, les couches de marquage et intermédiaires adjacentes ayant des indices de réfraction différents, et pendant la gravure de la couche supérieure (2,3), on détecte optiquement les discontinuités d'indice de réfraction, puis on arrête la gravure lorsque la séquence desdites discontinuités correspond à une séquence de référence (Sréf) représentative des épaisseurs des couches intermédiaires.

## Description

L'invention concerne un procédé de fabrication de composants semi-conducteurs.

L'invention s'applique au contrôle de la profondeur de gravure pendant la fabrication de ces composants.

Les technologies de fabrication des composants optoélectroniques font appel à un traitement de gravure sèche tel que la technique dite de gravure ionique réactive (Reactive Ion Etching en terminologie anglo-saxonne).

Ces techniques nécessitent un contrôle in situ de la profondeur de gravure dans la structure constituant le composant.

On utilise habituellement l'interférométrie laser pour effectuer ce contrôle dans le cas d'une structure en couches minces.

L'interférométrie laser permet de réaliser des mesures à partir d'un faisceau laser réfléchi durant la gravure. Le signal réfléchi que l'on enregistre, réponse de la structure, est fonction de la vitesse de gravure et de la complexité des indices de réfraction de cette structure.

Pendant la gravure d'une structure composée de différentes couches de matériau, chaque interface engendre une discontinuité dans le signal réfléchi. La dérivée de ce signal (au sens mathématique du terme) permet de faire apparaître un pic qui peut être utilisé pour détecter une interface particulière.

Cette propriété s'utilise pour contrôler précisément la profondeur de gravure en insérant une couche de marquage dans la structure à l'endroit où la croissance doit être arrêtée. L'opérateur ou l'ordinateur de commande peut alors détecter l'interface et arrêter le traitement de gravure.

La méthode qui vient d'être décrite présente des difficultés de mise en oeuvre car elle devient incertaine dès lors qu'il apparaît des pics parasites dans le signal réponse ou que la structure du composant présente de multiples interfaces.

Pour remédier au problème de l'apparition de pics parasites, il est prévu sur certains systèmes interférométriques installés sur des équipements de gravure sèche, d'ouvrir une fenêtre temporelle de détection et d'analyse qui permet de s'affranchir de tous les pics parasites tombant en dehors de ladite fenêtre.

Or cette solution nécessite une connaissance de la vitesse de gravure et de l'épaisseur du matériau à graver afin d'ouvrir la fenêtre de détection et d'analyse du signal réfléchi lorsque la profondeur de gravure s'approche du lieu de l'interface.

D'autre part cette méthode n'est pas fiable car elle ne permet pas de résoudre le problème de l'apparition de pics aléatoires.

La présente invention permet de résoudre ces problèmes. A cette fin le procédé selon l'invention comporte l'utilisation d'au moins un ensemble de couches de marquage ou "marqueurs" séparées par des couches intermédiaires d'indice de réfraction différent permettant de produire un signal réponse (signal réfléchi) comportant une séquence représentative des discontinuités d'indice entre marqueurs et couche intermédiaires.

L'invention a plus particulièrement pour objet un procédé de fabrication d'un composant semi-conducteur, ledit procédé comportant au moins une étape de gravure d'une ou plusieurs couche(s) supérieure(s) formée(s) sur un substrat, la ou les épaisseur(s) de ladite gravure étant définie(s) par une position verticale déterminée, principalement caractérisé en ce qu'il comprend les étapes suivantes :
a) faire croître, avant la formation de la ou desdites couche(s) supérieure(s), au moins un ensemble formé par des couches de marquage séparées par des couches intermédiaires, d'épaisseurs prédéterminées, les couches de marquage et intermédiaires adjacentes ayant des indices de réfraction différents,
b) pendant la gravure de la couche supérieure, détecter optiquement les discontinuités d'indice de réfraction, et arrêter la gravure lorsque la séquence desdites discontinuités correspond à une séquence de référence représentative des épaisseurs desdites couches intermédiaires.

Selon une autre caractéristique de l'invention l'ensemble de couches de marquage est formé d'une alternance de couches de marquage et intermédiaire irrégulière de manière à ce que les discontinuités d'indice correspondent à une séquence présentant une irrégularité. Cette caractéristique permet de discriminer ladite séquence d'une séquence correspondant à un bruit périodique ou de discriminer ladite séquence avec la séquence que donne une structure présentant un empilement périodique.

Selon une autre caractéristique de l'invention, le procédé consiste à faire croître plusieurs ensembles de couches de marquage séparées par des couches intermédiaires, situés à des niveaux distincts de la structure et produisant des séquences distinctes dues aux discontinuités d'indice des couches qui les constituent. Cette caractéristique permet de contrôler différentes profondeurs de gravures réalisées sur une même structure.

D'autres avantages et particularités de l'invention apparaîtront à la lecture de la description qui est faite ci-après et qui est donnée à titre d'exemple illustratif et non limitatif et en regard des dessins sur lesquels:
- la figure 1A, représente un schéma de structure permettant de mettre en oeuvre le procédé selon l'invention,
- la figure 1B, représente de façon schématique le détail de l'ensemble de couches de marquage selon la figure 1A.
- la figure 2, représente le schéma d'une structure selon une variante du procédé,
- la figure 3, représente le schéma du signal détecté 1 pendant la gravure,
- la figure 4, représente la dérivée première du signal de la figure 3 en fonction du temps,
- la figure 5, représente la dérivée seconde du signal de la figure 3 en fonction du temps,
- la figure 6, représente un laser semi-conducteur réalisé à partir du procédé selon l'invention.

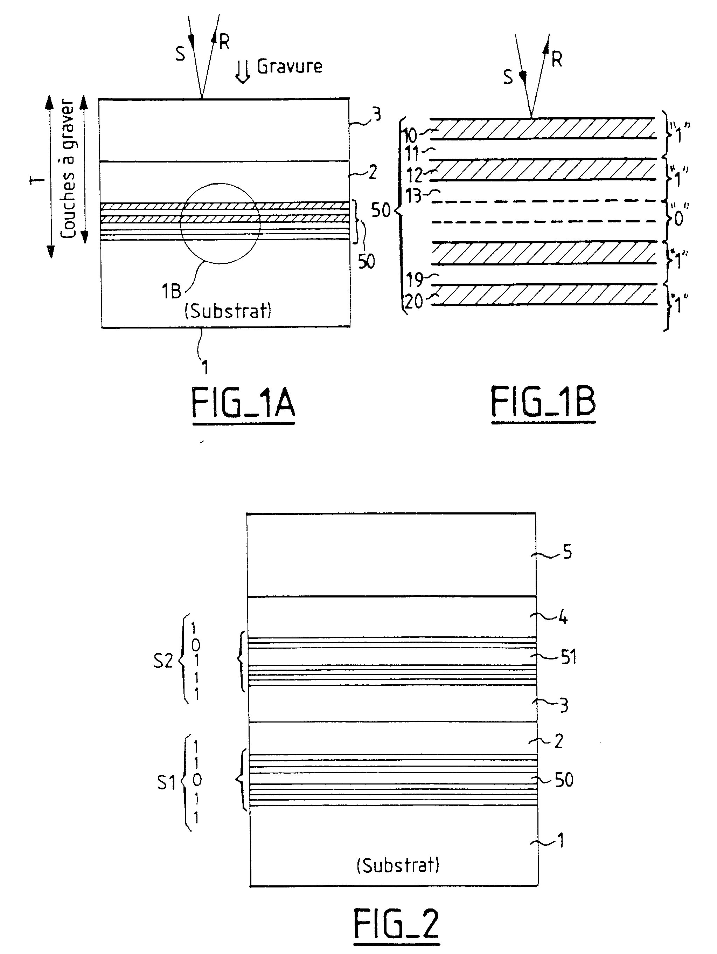

La description qui va suivre est faite relativement à une structure semi-conductrice simple illustrée par le schéma de la figure 1. Cette figure correspond à une vue en coupe transversale prise dans le sens de la largeur de la structure non encore gravée.

Typiquement selon cet exemple, la structure semi-conductrice comporte un substrat 1 réalisé en phosphure d'indium (InP) dopé en porteurs de type n. Le substrat peut être recouvert d'une couche tampon non représentée destinée à faciliter la croissance par épitaxie des différentes couches à empiler dénommée dans la suite couches supérieures. Les couches empilées classiquement au-dessus du substrat sont constituées par exemple par une première couche de matériau quaternaire de type GaInAsP enterrée sous une couche réalisée dans un matériau de type III-V tel que l'InP.

L'invention s'applique à toute autre structure semi-conductrice par exemple à une structure à l'arséniure de gallium AsGa ou AlGaAs.

Selon le procédé conforme à l'invention, on fait croître par épitaxie sur le substrat 1, un ensemble 50 formé par des couche de marquage 10,12,.,.20 séparées par des couches intermédiaires 11,13,..19. Les matériaux choisis présentent des indices de réfraction différents. Dans cet exemple on choisi de préférence un matériau quaternaire de type GaInAsP pour les couches de marquage 10, 12 ... et un matériau tel que l'InP pour les couches intermédiaires.

Pour obtenir une séquence régulière, il suffit que l'alternance des couches d'indice différent soit régulière et que ces couches soient de même épaisseur. En revanche pour obtenir une séquence présentant une irrégularité (cf. figure 1B), il faut que l'une ou plusieurs des couches intermédiaires (13 sur cette figure) soit plus épaisse que les autres couches. L'épaisseur des couches peut être de 0,4 nm (4Å) ou plus. Bien entendu l'épaisseur et la composition des couches sont choisies de manière à être compatibles avec la sensibilité du système de détection.

On choisit de préférence un ensemble formé de couches qui présentent une discontinuité d'indice irrégulière par exemple une séquence 11011 ou 10111 ou encore 1101000110 plutôt qu'une séquence 1010101... qui pourrait être confondue par le système de détection avec un bruit périodique ou avec des couches supérieures présentant cette périodicité.

Un détail représentant un ensemble 50 de couches de marquage est représenté sur la figure 1B. Dans le cas de la réalisation d'un laser, l'épaisseur de la couche supérieure est par exemple de 1000 Å tandis que l'épaisseur de chaque couche de marquage GaInAsP et intermédiaire InP est par exemple de 20 Å. On obtient avec un ensemble de 400 Å d'épaisseur et dont chaque couche aurait 20 Å d'épaisseur, une séquence de 8 bits.

La figure 2 illustre une variante de réalisation consistant à enterrer un deuxième ensemble 51 de couches de marquage correspondant à une séquence distincte du premier par exemple la séquence 52 "10111" si la première S1 est "11011". Cet exemple est intéressant dans le cas où l'on désire réaliser un composant semi-conducteur nécessitant deux attaques successives dans des conditions expérimentales différentes (nature des gaz ou débit des gaz). Dans ce cas, on effectue la gravure des couches supérieures 5, 4 avec une première condition expérimentale puis on continue cette gravure avec une autre condition expérimentale pour les couches 2, 30 situées au-dessous du premier ensemble de marquage 50.

Cette structure est par exemple utilisée lors de la réalisation d'un réflecteur de Bragg de type "deep ridge". Les matériaux utilisés seront alors InP (1), GaInASP (2), InP (3), GaInAsP (4).

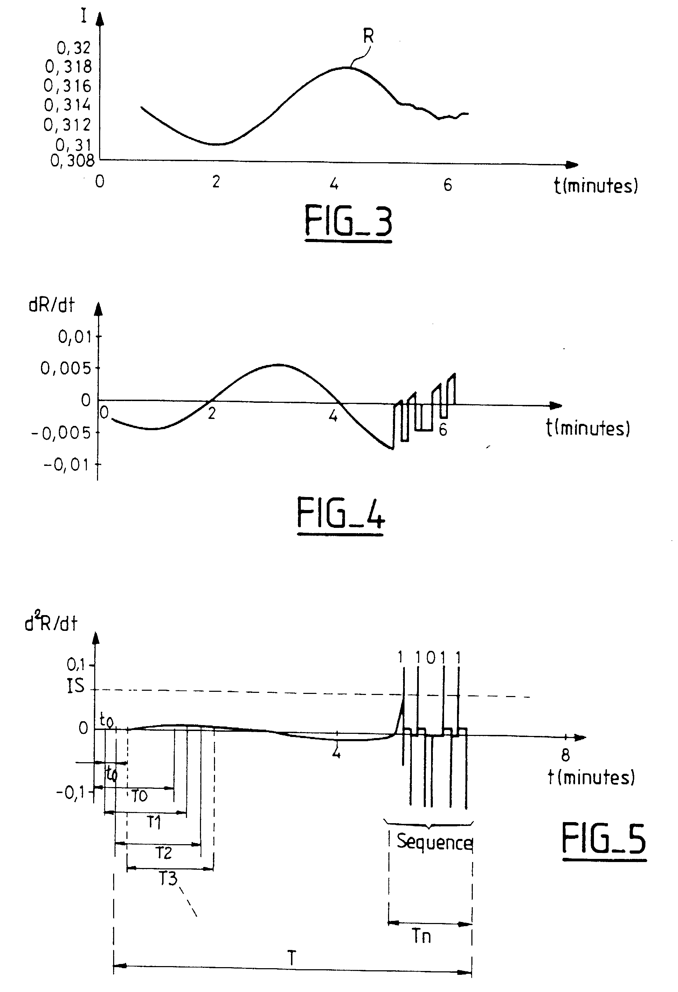

Les figures 3, 4 et 5 représentent respectivement le signal du faisceau laser réfléchi R par la structure du composant pendant la gravure puis sa dérivée première dR/dt puis sa dérivée seconde d²R/dt. Le signal R est détecté par un système d'interférométrie laser classique non représenté. Le système d'interférométrie comporte des moyens de détection de filtrage et de numérisation pour traiter le signal détecté R. Il comporte à cette fin une unité de traitement temps réel du signal pilotée par un programme qui effectue le calcul de la dérivée première du signal et de la dérivée seconde du signal permettant de mettre en évidence la séquence S1 dès sa détection.

De manière pratique, le signal S du faisceau laser est émis pendant la durée de l'opération de gravure, et le signal R réfléchi par la structure est détecté et traité en temps réel.

Le signal détecté est analysé par intervalles de temps successifs T₀, T₁, ..., Tₙ pris sur la durée totale T de la gravure. Le signal détecté pendant chaque intervalle de temps est échantillonné avec une période d'échantillonnage to pour obtenir p échantillons si la séquence à détecter comporte p bits. Les échantillons obtenus sont comparés à un seuil IS programmé à cet effet.

Dès que le système détecte un ou plusieurs dépassements de ce seuil IS, la séquence de valeurs dépassant ce seuil est comparée à une séquence de référence Sréf mémorisée dans le système. Bien sûr le logiciel permettant d'effectuer cette analyse est programmé de manière à glisser d'un intervalle d'analyse au suivant T₀ à T₁ ..., etc., de manière à reconnaître la séquence S1 même si celle-ci se trouve répartie sur deux intervalles d'analyse successifs. Le chevauchement des intervalles d'analyse est de to comme représenté sur la figure 5.

Dans le cas où un deuxième ensemble de marquage 51 est prévu dans la structure le seuil de détection IS prévu peut être le même mais la séquence de référence sera différente puisqu'elle correspondra à la discontinuité d'indice présenté par cet ensemble 51 de couches de marquage choisi volontairement différent du premier.

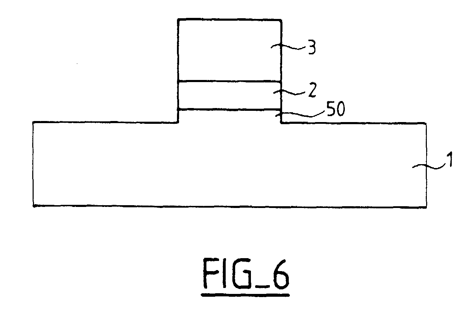

La figure 6, illustre un exemple de composant obtenu à partir du procédé selon l'invention. Il s'agit d'un laser semi-conducteur. Ce composant comporte aux endroits non gravés de la structure, l'ensemble 50 ayant servi au contrôle de la gravure. L'homme de métier choisira bien sûr des matériaux pour les couches formant l'ensemble 50 ne perturbant pas le fonctionnement du composant réalisé.

## Revendications

1. Procédé de fabrication d'un composant semi-conducteur, ledit procédé comportant au moins une étape de gravure d'une ou plusieurs couche(s) supérieure(s) formée(s) sur un substrat, la ou les épaisseur(s) de ladite gravure étant définie(s) par une position verticale déterminée, caractérisé en ce qu'il comprend les étapes suivantes :
a) faire croître, avant la formation de la ou desdites couche(s) supérieure(s) (2,3), au moins un ensemble (50) formé par des couches de marquage (10,12,...,20) séparées par des couches intermédiaires (11,13,...,19) d'épaisseurs prédéterminées, les couches de marquage et intermédiaires adjacentes ayant de indices de réfraction différents,
b) pendant la gravure de la couche supérieure détecter optiquement les discontinuités d'indice de réfraction, et arrêter la gravure lorsque la séquence desdites discontinuités correspond à une séquence de référence (Sréf) représentative des épaisseurs desdites couches intermédiaires.

2. Procédé de fabrication d'un composant semi-conducteur selon la revendication 1, caractérisé en ce que l'ensemble de couches marquage (50,51) est formés d'une alternance de couches de marquage et intermédiaire irrégulière de manière à ce que les discontinuités d'indice correspondent à une séquence présentant une irrégularité afin de discriminer ladite séquence d'une séquence correspondant à un bruit périodique ou de discriminer ladite séquence avec la séquence que donne une structure présentant un empilement périodique.

3. Procédé de fabrication d'un composant semi-conducteur selon la revendication 1, caractérisé en ce qu'il consiste à faire croître plusieurs ensembles (50,51) de couches de marquage séparées par des couches intermédiaires, situés à des niveaux distincts de la structure et produisant des séquences (51,52) distinctes dues aux discontinuités d'indice des couches qui les constituent afin de contrôler différentes profondeurs de gravures réalisées sur une même structure.

4. Composant semi-conducteur réalisé sur un substrat par gravure d'une ou plusieurs couches supérieures, caractérisé en ce qu'il comporte en outre enterré sous les couches supérieures non gravées au moins un ensemble formé par des couches de marquage (10,12,...,20) séparées par des couches intermédiaires (11,13,...,19) d'épaisseurs prédéterminées, les couches de marquage et intermédiaires adjacentes ayant un indice de réfraction différent.
